# EUROPEAN PATENT APPLICATION

(11) **EP 4 654 780 A1**
(43) Date of publication of application: **26.11.2025**
(21) Application number: 25315157.5
(22) Date of filing: 06.05.2025
(51) Int. Cl.: H10D 30/47, H10D 64/23, H10D 62/17, H10D 64/62, H10D 64/27, H10D 62/85

(54) **NORMALLY-OFF HEMT DEVICE WITH IMPROVED DYNAMIC PERFORMANCES, AND MANUFACTURING METHOD THEREOF**

(30) Priority: 22.05.2024 IT 202400011572
(71) Applicant: STMicroelectronics International N.V., 1228 Plan-les-Ouates, Geneva (CH)
(72) Inventor: Tringali, Cristina, 96011 Augusta (SR) (IT); Constant, Aurore, 37100 Tours (FR); Chini, Alessandro, 41126 Modena (MO) (IT); Castagna, Maria Eloisa, 95123 Catania (CT) (IT); Giorgino, Giovanni, 95041 Caltagirone (CT) (IT); Iucolano, Ferdinando, 95030 Gravina di Catania (CT) (IT)
(74) Representative: Studio Torta S.p.A.

(57) **Abstract**

HEMT device (20) comprising a trench-source contact (36) which includes a first conductive portion (36a) and a second conductive portion (36b) superimposed on the first conductive portion. The first conductive portion is of a metal material which has a work function value lower than the work function value of the metal material of the second conductive portion.

## Description

### Technical Field

The present invention relates to a HEMT device and manufacturing method thereof, in particular to a normally-off HEMT device with reduced degradation in the ON-state resistance.

### State of the Art

HEMT transistors with heterostructure are known, in particular in gallium nitride (GaN) and gallium aluminum nitride (AlGaN), at the interface of which a conductive channel may be formed, in particular a two-dimensional electron gas (2DEG). For example, HEMT transistors are appreciated for use as high-frequency switches and as power switches, owing to their high breakdown threshold and high electron mobility and charge carrier density of their conductive channel. Furthermore, the high current density in the conductive channel of the HEMT transistor allows to obtain a low ON-state resistance (or simply R_{ON}) of the conductive channel.

In HEMT transistors of known type, in which a gate electrode extends above the AlGaN/GaN heterostructure, the conductive channel is normally-on, as a high density of charge carriers is present even in the absence of a gate voltage applied to the heterostructure.

For safety reasons and to simplify the driving circuits of HEMT transistors, therefore allowing their use in industrial applications, HEMT transistors have been introduced in which the conductive channel is normally-off. Different approaches have been proposed to obtain normally-off HEMTs, such as for example recessed-gate or p-GaN gate HEMTs.

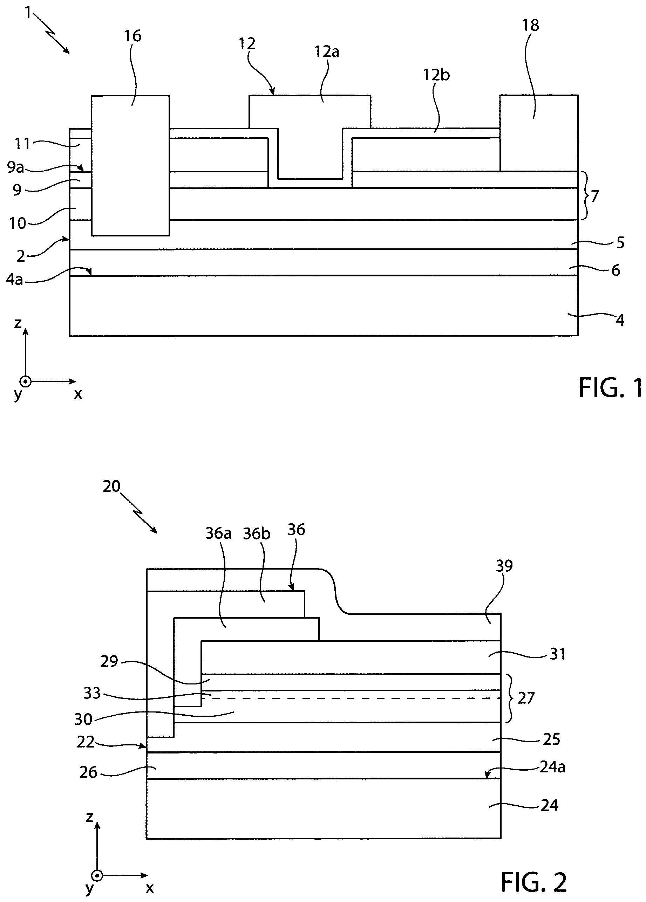

Figure 1 schematically illustrates a portion of HEMT device 1 of a type known to the Applicant, in a triaxial system of axes x, y, z orthogonal to each other, in a lateral sectional view on the xz plane. In particular, the HEMT transistor 1 is a recessed-gate transistor.

The HEMT transistor 1 includes a semiconductor body 2, which in turn comprises a substrate 4, a buffer layer 6 extending onto a face 4a of the substrate 4, a buried layer 5, of P-type doped GaN, and a heterostructure 7 extending onto the buried layer 5.

The substrate 4 is for example of silicon, or silicon carbide (SiC) or sapphire (Al₂O₃), or GaN.

The buffer layer 6 is of aluminum gallium nitride (AlGaN), or gallium nitride (GaN), of an intrinsic or compensated type (e.g. carbon and/or iron doping may be employed to compensate undesired N-type impurities present as a consequence of the manufacturing process).

The heterostructure 7 includes, in particular, a channel layer 10, extending over the buried layer 5, and a barrier layer 9, extending over the channel layer 10. The channel layer 10 is of gallium nitride (GaN) of an intrinsic type; the barrier layer 9 is of non-doped aluminum gallium nitride (AlGaN).

Furthermore, an insulating or dielectric material layer 11 extends above the barrier layer 9.

The HEMT transistor 1 further comprises a source electrode 16 and a drain electrode 18, both of conductive material, such as for example titanium (Ti), aluminum (Al), tantalum (Ta) or titanium nitride (TiN).

The drain electrode 18 extends through the insulating layer 11, above the heterostructure 7, more precisely in electrical contact with an upper surface 9a of the barrier layer 9 without penetrating within the barrier layer 9; the source electrode 16 extends through the insulating layer 11 and in depth into the semiconductor body 2, completely through the heterostructure 7 (in electrical contact with the channel layer 10 and with the 2DEG) and in part into the buried layer 5, ending within the buried layer 5.

The HEMT transistor 1 further comprises a gate region 12, extending in depth into the semiconductor body 2 up to reaching the interface between the barrier layer 9 and the channel layer 10. In particular, the gate region 12 comprises a gate conductive region 12a and a gate dielectric 12b; the gate dielectric 12b surrounds the gate conductive region 12a, electrically insulating it from the semiconductor body, in a per se known manner.

One of the critical issues related to GaN-based HEMT power devices concerns the need to find a trade-off between the degradation of the R_{ON} when the device is turned-on (transition from the off-state to the on-state), in particular due to high drain biasing values, e.g. 400-600V, and the breakdown voltage value in the off-state. In fact, to obtain acceptable values of vertical leakage current it is necessary to compensate for the unintentional N-type doping of GaN by incorporating other elements, such as Iron and/or Carbon. However, the presence of these elements is one of the main reasons for the degradation of R_{ON}. In fact, such degradation may be attributed to the increase in ON-resistance between the gate and drain terminals. The reasons are related, at least in part, to trapping mechanisms (e.g., interface traps, hot electron injection, and traps in the buffer layer 6). Therefore, it is crucial to minimize such causes.

As illustrated in Figure 1 and previously described, a solution known to the Applicant envisages electrically coupling the buried layer 5 to the source terminal 16, since it allows or favors the injection of holes into the buffer layer 6 with a high Carbon content during switching from the off-state to the on-state, avoiding the accumulation of negative charge in the buffer layer 6 and the resulting depletion of the 2DEG (therefore avoiding the degradation of R_{ON}). Furthermore, the buried layer 5 plays an important role when the device works under stress conditions caused by the application of a bias of the substrate 4.

However, the solution of Figure 1 is not optimal as it does not allow to obtain a good ohmic contact simultaneously with the buried layer 5 and with the channel layer 10; the solution of Figure 1 therefore does not allow to fully exploit the benefit obtained from the action of the buried layer to mitigate the effect of the ionized carbon atoms on the R_{ON} of the device and, at the same time, to reshape the electric field within the region between gate and drain terminals (also known as "gate-drain access region").

The need is therefore felt to provide a HEMT device, and a manufacturing method thereof, such as to overcome the drawbacks of the prior art.

### Summary

According to the present invention, a HEMT device and a manufacturing method thereof are provided, as defined in the attached claims.

### Brief Description of the Drawings

For a better understanding of the present invention, some embodiments thereof are now described, purely by way of non-limiting example, with reference to the attached drawings, wherein:
- Figure 1 schematically illustrates, in a lateral sectional view, a portion of a HEMT according to an embodiment of a known-type;
- Figure 2 schematically illustrates, in a lateral sectional view, a first portion of a HEMT according to an embodiment of the present invention;
- Figure 3 schematically illustrates, in lateral sectional view, a second portion which includes the first portion of Figure 2, of a HEMT according to an embodiment of the present invention;
- Figure 4 schematically illustrates, in lateral sectional view, a second portion which includes the first portion of Figure 2, of a HEMT according to a further embodiment of the present invention;
- Figures 5A-5E illustrate manufacturing steps of the HEMT of Figure 2, according to an embodiment of the present invention;
- Figures 6A-6E illustrate manufacturing steps of the HEMT of Figure 2, according to a further embodiment of the present invention; and
- Figure 7 schematically illustrates, in a lateral sectional view, a portion of a HEMT according to a further embodiment of the present invention.

### Description of Embodiments

Figure 2 schematically illustrates a portion of a HEMT device 20 in a triaxial system of axes x, y, z orthogonal to each other, in lateral sectional view on the xz plane.

The device 20 comprises a semiconductor body 22, which in turn comprises a substrate 24, a buffer layer 26 extending onto a face 24a of the substrate 24, a buried layer 25, of P-type doped GaN, and a heterostructure 27 extending onto the buried layer 25.

The substrate 24 is for example of silicon, or silicon carbide (SiC) or sapphire (Al₂O₃), or GaN.

The buffer layer 26 is of aluminum gallium nitride (AlGaN), or gallium nitride (GaN). N-type impurities are naturally present as a consequence of the manufacturing process of the buffer layer 26, therefore in an embodiment a P-type doping (e.g. Carbon and/or Iron doped) is introduced to compensate the original, undesired, N-type charges. In case the buffer layer 26 is of intrinsic type from the onset, no P-type doping is required.

The heterostructure 27 includes, in particular, a channel layer 30, extending over the buried layer 25, and a barrier layer 29, extending over the channel layer 30. The conductive channel, in particular the two-dimensional electron gas (2DEG) is formed, in use, at an interface 33 between the channel layer 30 and the barrier layer 29.

The channel layer 30 is of gallium nitride (GaN) of an intrinsic type (undoped); the barrier layer 29 is of non-doped aluminum gallium nitride (AlGaN). In one embodiment, the barrier layer 29 is of Alₓ₂GaN, with x2 comprised between 15% and 30%.

The buffer layer 26 has for example a thickness, along the Z axis, comprised between 1 µm and 8 µm, for example 5 µm.

The buried layer 25 has for example a thickness, along the Z axis, comprised between 100 nm and 500 nm, and P-type doping for example in the range 10¹⁸-3·10¹⁹ at/cm³.

The channel layer 30 has for example a thickness, along the Z axis, comprised between 10 nm and 1 µm, in particular between 100 nm and 500 nm and is of undoped type or intrinsic type.

The barrier layer 29 has for example a thickness, along the Z axis, comprised between 5 nm and 30 nm, for example 15 nm, and is of undoped type or intrinsic type.

Furthermore, the device 20 comprises an insulating or dielectric material layer 31 which extends above the barrier layer 29. The insulating layer 31 has for example a thickness comprised between 50 nm and 200 nm. The insulating layer 31 may comprise a single insulating or dielectric material or may include a plurality of insulating and/or dielectric materials superimposed to form a stack. Such materials include, for example, silicon oxide, silicon nitride, aluminum oxide.

The HEMT transistor 20 further comprises a source electrode 36. The source electrode 36 extends through the insulating layer 31 and in part into the semiconductor body 22, in direct electrical contact with the channel layer 30 (and with the 2DEG, when present during use) and with the buried layer 25, ending within the semiconductor body 22.

Optionally, a passivating or insulating material layer 39 (for example, SiN) extends above the source electrode 36, to protect and electrically insulate the same. Electrical contact regions are formed through the passivating layer for biasing the source terminal 36, in a per se known manner.

In particular, according to the invention, the source electrode 36 comprises a first conductive region 36a and a second conductive region 36b, superimposed on each other.

The first conductive region 36a extends completely through the barrier layer 29 and in part through the channel layer 30, ending within the channel layer 30, and is in direct electrical contact with the channel layer 30.

In particular, the first conductive region 36a extends completely through the two-dimensional gas 2DEG of the channel layer 30. The first conductive region 36a is of one or more materials that allow an ohmic-type contact with the channel layer 30. In particular, the first conductive region 36a is of metal material with a reduced work function value (e.g., comprised between 3.5 and 4.5 eV).

In one embodiment, the first conductive region 36a includes titanium (Ti) or tantalum (Ta). In a further embodiment, the first conductive region 36a comprises two or more superimposed layers of conductive materials, such as for example Ti (or Ta), AlCu, TiN (or TaN). In one embodiment, the first conductive region 36a is a Ti/AlCu/TiN stack. Alternatively to titanium, tantalum can be used (e.g., Ta/AlCu/TaN or Ta/AlCu/Ta). When the conductive region 36a comprises the aforementioned plurality of superimposed layers, the titanium (or tantalum) is in direct contact with the channel layer 30.

In the embodiment in which the first conductive region 36a is a Ti/AlCu/TiN stack, the Ti (or Ta) layer has a thickness equal to about 3-20 nm, the AlCu layer has a thickness equal to about 100-300 nm and the TiN (or TaN) layer has a thickness equal to about 10-40 nm.

Using a stack for the first conductive region 36a allows the resistivity of the conductive region 36a to be reduced and thermal dissipation to be improved.

The second conductive region 36b extends completely through the heterostructure 27 (i.e., completely through the barrier layer 29 and the channel layer 30) and through part of the buried layer 25, ending within the buried layer 25, and is in direct electrical contact with the buried layer 25.

The second conductive region 36b is of one or more materials that allow an ohmic-type contact with the buried layer 25. In particular, the second conductive region 36b is of metal material with a high work function value (e.g., comprised between 4.5 and 5.6 eV). In particular, the work function value of the first conductive region 36a is selected to be lower than the work function value of the second conductive region 36b. In one embodiment, the second conductive region 36b includes nickel (Ni) or ruthenium (Ru). In a further embodiment, the second conductive region 36b comprises two or more superimposed layers of conductive materials, such as for example Ni, Au, Pt, Ag. In one embodiment, the second conductive region 36b is a stack of Ni/Au or Ni/Pt/Au or Ni/Ag/Au or Ni/Ag. When the conductive region 36b comprises the aforementioned plurality of superimposed layers, the Nickel is in direct contact with the buried layer 25.

In the embodiments in which the second conductive region 36b is a stack (Ni/Au or Ni/Pt/Au or Ni/Ag/Au), the Ni layer has a thickness equal to about 5-50 nm. The other layers above Ni are useful to reduce the resistivity, and are optional. For example, the thickness of Au layer is in the range 5-100 nm.

The use of one of the aforementioned stacks for the second conductive region 36b allows the resistivity of the conductive region 36b to be reduced and the thermal dissipation to be improved.

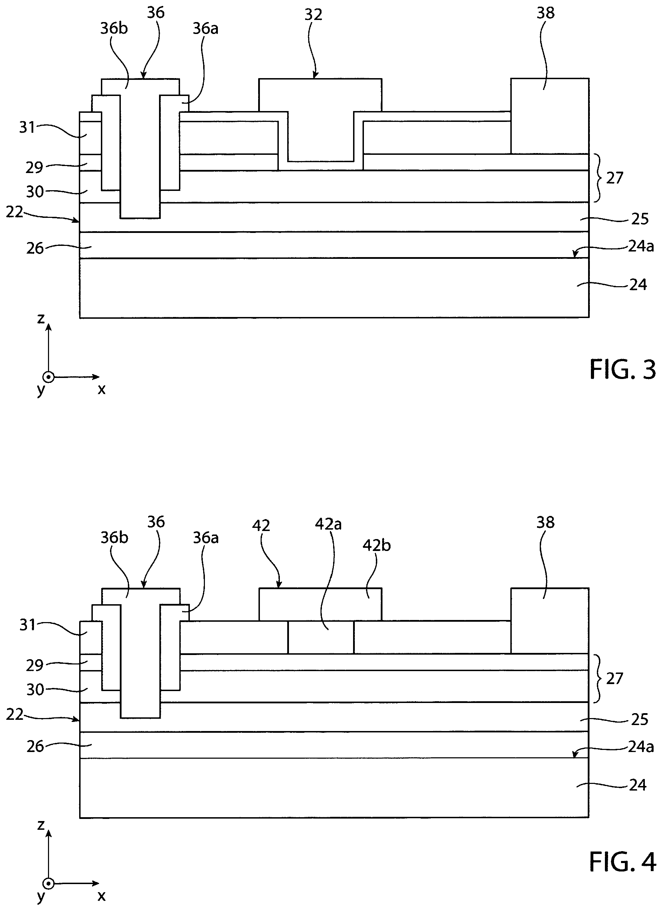

As schematically illustrated in Figure 3, the device 20 further comprises a drain electrode 38, of conductive material, such as for example titanium (Ti), aluminum (Al), tantalum (Ta) or titanium nitride (TiN). The drain electrode 38 extends through the insulating layer 31, above the heterostructure 27, more precisely in electrical contact with an upper surface of the barrier layer 29 without penetrating within the barrier layer 29.

Furthermore, the device 20 comprises a gate terminal 32 extending between the source terminal 36 and the drain terminal 38. The gate terminal 32 is of the recessed-gate or trench-gate type, similarly to what has been illustrated and described with reference to Figure 1.

Alternatively, as illustrated in Figure 4, the gate terminal is of the "doped-gate" type and is identified with the reference number 42. With reference to Figure 4, the gate terminal 42 extends above the heterostructure 27, between the source electrode 36 and the drain electrode 38 and at a distance therefrom. In particular, the gate terminal 42 comprises a doped-gate region 42a of P-type doped gallium nitride (GaN), for example doped by magnesium (Mg), and a gate electrode 42b, of conductive material, such as for example tantalum (Ta), tantalum nitride (TaN), titanium nitride (TiN), palladium (Pa), tungsten (W), tungsten silicide (WSi₂), titanium aluminum (Ti/Al) or nickel gold (Ni/Au), extending above the doped-gate region 42a. The structure formed by the gate electrode 42b and the doped-gate region 42a is known in the state of the art as "p-GaN gate". As known, the doped-gate region 42a modifies the band diagram of the heterostructure 27 in such a way that, in the absence of a gate voltage applied to the gate electrode 42b, the 2DEG is depleted in the area below the doped-gate region 42a. As a result, in the absence of an applied gate voltage, there is no conductive channel connecting the source electrode 36 and the drain electrode 38.

The doped-gate region 42a has a thickness comprised for example between 10 nm and 200 nm, for example 50 nm.

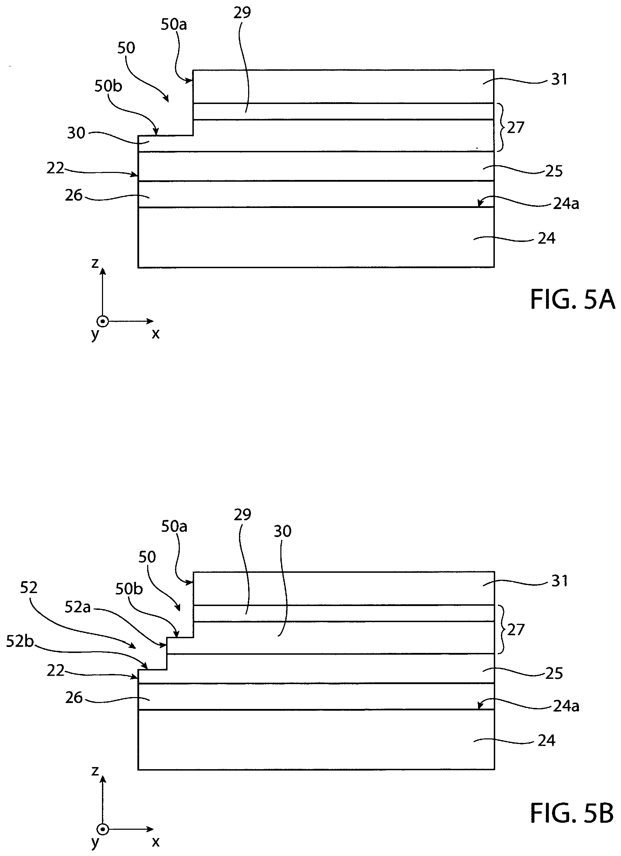

With reference to Figures 5A-5E, manufacturing steps of the portion of the device 20 illustrated in Figure 2 are now described, limitedly to the formation of the source terminal 36 and according to one embodiment. Figures 5A-5E are lateral sectional views on the xz plane.

With reference to Figure 5A, after having formed the semiconductor body 22 in a per se known manner (e.g., by one or more epitaxial growths on the substrate 24, with appropriate doping), one or more masked etching steps are performed (e.g., by photolithography steps, known per se) of the semiconductor body 22 to remove selective portions of the insulating layer 31, the barrier layer 29 and the channel layer 30 (in part). A trench 50 is thus formed which extends into the semiconductor body 22 and ends within the channel layer 30. The trench 50 has a side wall 50a and a bottom wall 50b.

With reference to Figure 5B, a further etching step of the semiconductor body 22 is performed at the bottom wall 50b of the trench 50, up to reaching the buried layer 25; a second trench 52 is thus formed which ends within the buried layer 25. The second trench 52 has a respective side wall 52a and a respective bottom wall 52b.

The extension of the bottom wall 50b, along the x axis and in lateral sectional view, is greater than the corresponding extension of the bottom wall 52b. In other words, the second trench 52 is completely contained within the first trench 50 and has a base area (bottom wall 52b) smaller than the base area (bottom wall 50b) of the first trench 50.

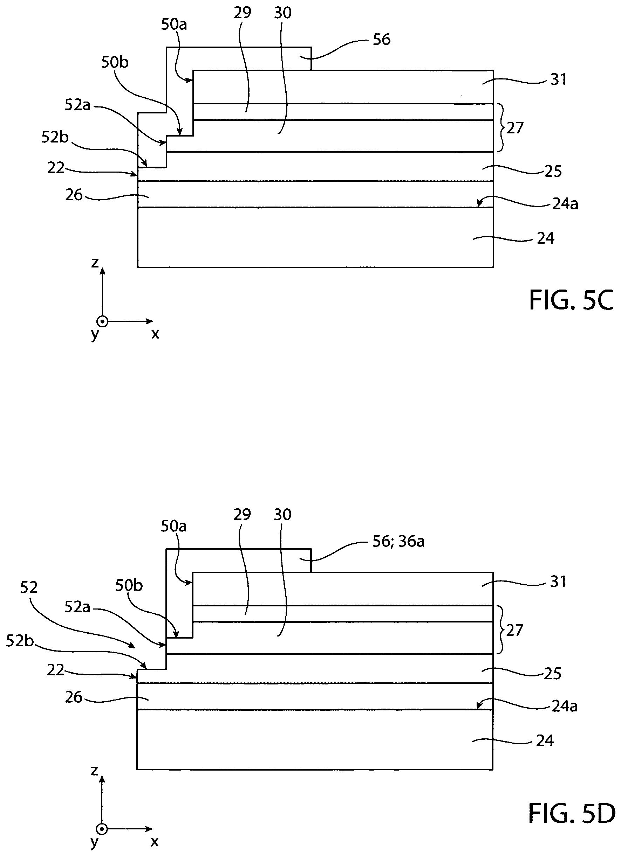

Then, Figure 5C, a conductive material deposition step is performed, forming a first filling layer 56 which, in subsequent manufacturing steps, will form the first conductive region 36a. In particular, a titanium or tantalum deposition step is performed. Alternatively, a series of depositions are performed to form a stack including, as mentioned, Ti or Ta, AlCu, TiN or Ta or TaN. The first filling layer 56 extends along the side walls 50a and 52a, and also on the remaining portion of the bottom wall 50b and on the bottom wall 52b of the respective trenches 50 and 52.

Then, Figure 5D, a masked etching step is performed to remove portions of the first filling layer 56 at the side wall 52a and the bottom wall 52b of the second trench 52; the first filling layer 56 remains at the side wall 50a and the bottom wall 50b of the first trench 50, forming the first conductive region 36a.

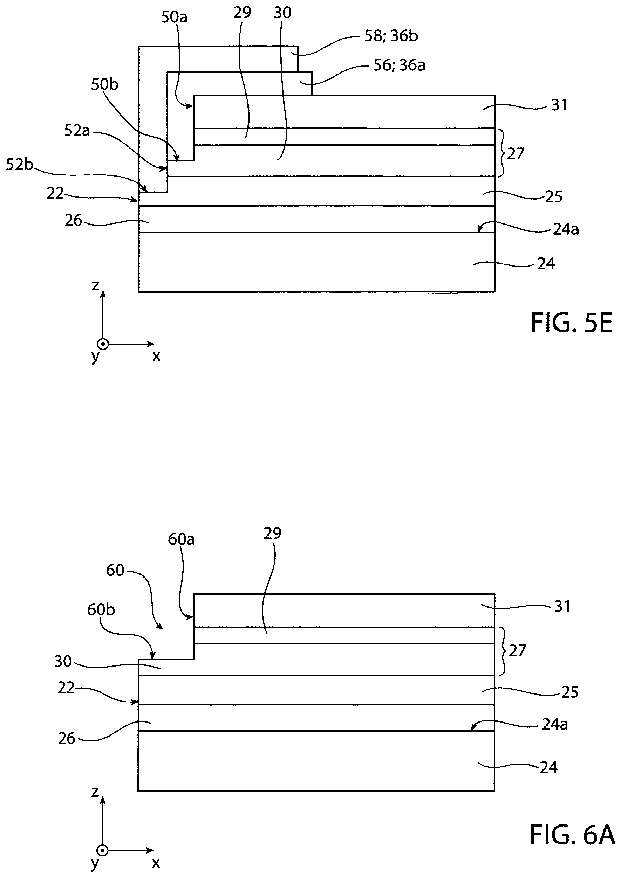

Then, Figure 5E, a further conductive material deposition step is performed, forming a second filling layer 58 which will form the second conductive region 36b. In particular, a nickel deposition step is performed. Alternatively, a series of depositions are performed to form a stack including, as mentioned, Ni, Au, Ag, Pt. The second filling layer 58 extends onto the first filling layer 56 (at least at the portion of the first filling layer 56 which extends along the side wall 50a), along the side wall 52a and onto the bottom wall 52b of the trench 52.

To form the second filling layer 58 exclusively where desired (in particular, within the sole trenches 50 and 52), known-type patterning processes (e.g., deposition and subsequent etching or lift-off) may be used.

Optionally, a deposition step of passivating or insulating material (for example, SiN) above the second conductive region 36b is also performed, to protect and electrically insulate the same. Electrical contact regions are formed through the passivating layer for biasing the source terminal 36, in a per se known manner.

Then, an optional rapid thermal processing (RTP) step is performed, for example at a temperature comprised between 500 °C and 800 °C, to allow/favor the formation of ohmic contacts between the first conductive region 36a and the channel layer 30, and between the second conductive region 36b and the buried layer 25.

The device 20 of Figure 2 is thus obtained.

With reference to Figures 6A-6E, manufacturing steps of the portion of the device 20 illustrated in Figure 2 are now described as alternatives to the steps of Figures 5A-5E, limitedly to the formation of the source terminal 36 and according to a respective embodiment. Figures 6A-6E are lateral sectional views on the xz plane.

With reference to Figure 6A, after having formed the semiconductor body 22 in a per se known manner (e.g., by one or more epitaxial growths on the substrate 24, with appropriate doping), one or more masked etching steps are performed (e.g., by photolithography steps, known per se) of the semiconductor body 22 to remove selective portions of the insulating layer 31, the barrier layer 29 and the channel layer 30 (in part). A first trench 60 is thus formed which extends into the semiconductor body 22 and ends within the channel layer 30. The first trench 60 has a side wall 60a and a bottom wall 60b.

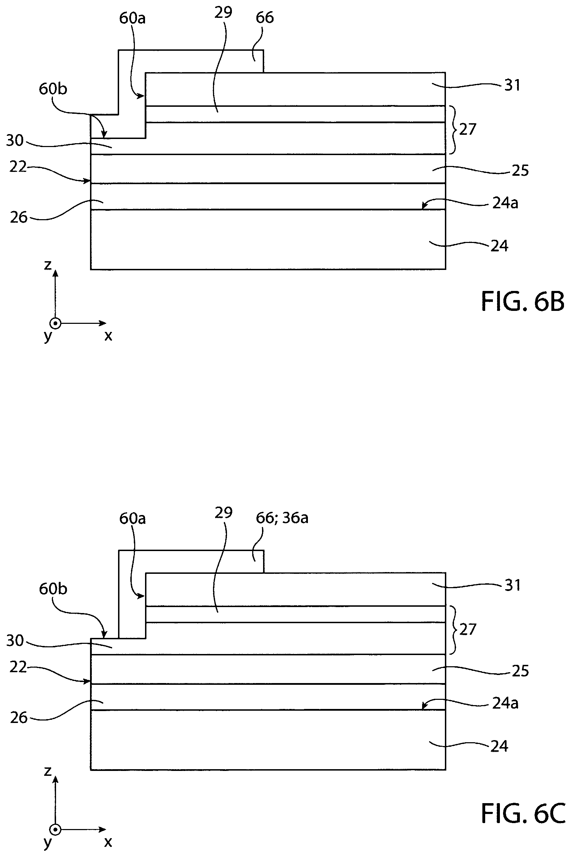

With reference to Figure 6B, a conductive material deposition step is performed, forming a first filling layer 66 which, in subsequent manufacturing steps, will form the first conductive region 36a. In particular, a titanium or tantalum deposition step is performed. Alternatively, a series of depositions are performed to form a stack including, as mentioned, Ti or Ta, AlCu, TiN or Ta or TaN. The first filling layer 66 extends along the side 60a and bottom walls 60b of the first trench 60.

Then, Figure 6C, a patterning step of the first filling layer 66 is performed, removing selective portions of the first filling layer 66 which extend at the bottom wall 60b of the first trench 60, preserving portions of the first filling layer 66 which extend at the side wall 60a. This step comprises for example a masked etching, in which the etching mask is shaped in such a way as to expose the portions of the first filling layer 66, which extend at the bottom wall 60b, to the etching chemistry. The bottom wall 60b of the first trench 60 is thus exposed, at least in part. An optional rapid thermal processing (RTP) step is then performed, for example at a temperature comprised between 500 °C and 800 °C, to allow/favor the formation of an ohmic contact between the first filling layer 66 and the channel layer 30.

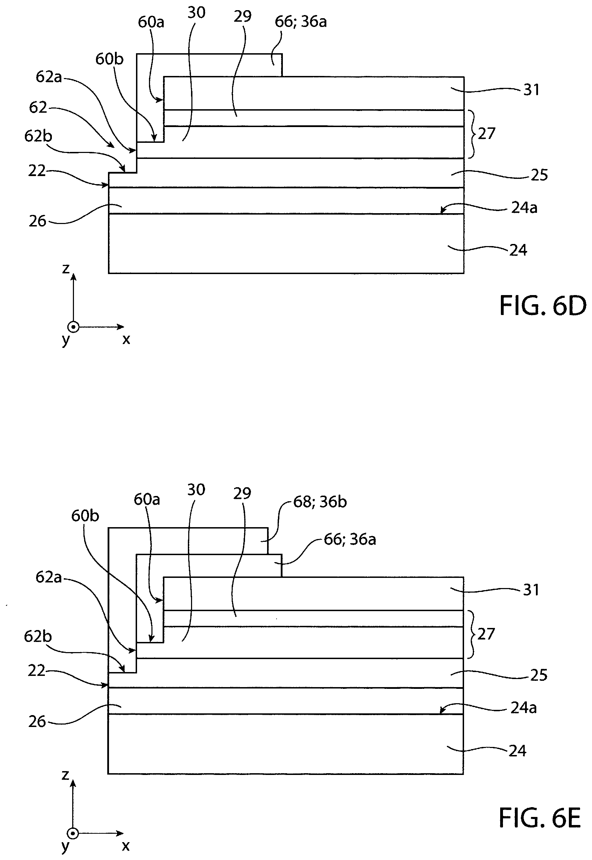

Then, Figure 6D, a further etching step of the semiconductor body 22 is performed at the bottom wall 60b of the first trench 60, up to reaching the buried layer 25; a second trench 62 is thus formed which ends within the buried layer 25. The second trench 62 has a respective side wall 62a and a respective bottom wall 62b.

The extension of the bottom wall 60b, along the x axis and in lateral sectional view, is greater than the corresponding extension of the bottom wall 62b. In other words, the second trench 62 is completely contained within the first trench 60 and has a base area (bottom wall 62b) smaller than the base area (bottom wall 60b) of the first trench 60.

Then, Figure 6E, a further conductive material deposition step is performed, forming a second filling layer 68 which will form the second conductive region 36b. In particular, a nickel deposition step is performed. Alternatively, a series of depositions are performed to form a stack including, as mentioned, Ni, Au, Ag, Pt. The second filling layer 68 extends onto the first filling layer 66 (at least at the portion of the first filling layer 66 which extends along the side wall 60a), along the side wall 62a and on the bottom wall 62b of the second trench 62.

To form the second filling layer 68 exclusively where desired (in particular, within the sole trenches 60 and 62), known-type patterning processes (e.g., deposition and subsequent etching or lift-off) may be used.

An optional rapid thermal processing (RTP) step is then performed, for example at a temperature comprised between 500 °C and 800 °C, to allow/favor the formation of an ohmic contact between the second filling layer 68 and the buried layer 25.

Optionally, a deposition step of passivating or insulating material (for example, SiN) above the second conductive region 36b is also performed, to protect and electrically insulate the same. Electrical contact regions are formed through the passivating layer for biasing the source terminal 36, in a per se known manner.

The previous RTPs may be carried out once at the end of the process.

The device 20 of Figure 2 is thus obtained.

Finally, it is clear that modifications and variations may be made to what has been described and illustrated herein without thereby departing from the scope of the present invention, as defined in the attached claims.

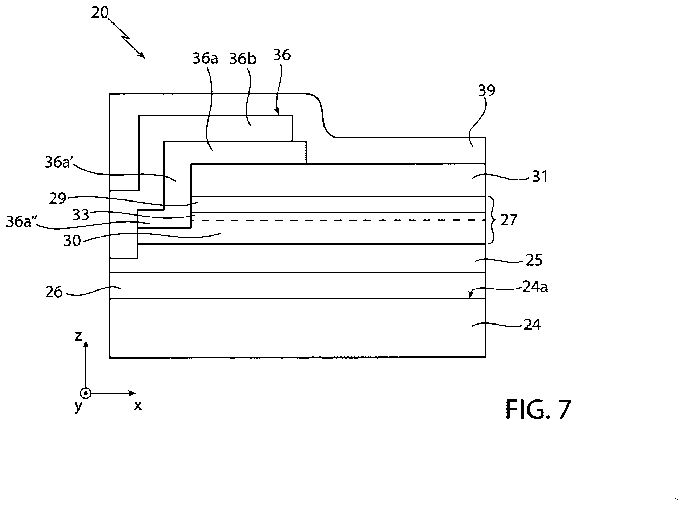

For example, Figure 7, the first conductive region 36a may extend, within the respective trench, with an "L" shape in lateral sectional view, i.e. including a portion 36a' parallel to the yz plane and a portion 36a" parallel to the xy plane, in mutual structural and electrical continuity. Both portions 36a' and 36a" are in direct electrical contact with the channel layer 30.

It is further noted that the ranges indicated in the present description are to be understood as including the boundaries values of the ranges.

Furthermore, according to a further embodiment, the first and the second conductive regions 36a, 36b may be insulated from each other by an insulating layer (not illustrated) which extends between the first and the second conductive regions 36a, 36b. In this case, in use, the first and the second conductive regions 36a, 36b may be biased with voltage values different from each other.

From what has been previously explained, the advantages that the present invention affords are evident.

In particular, an improvement in dynamic performances is observed due to a reduction in the ON-state drain-source resistance (R_{DSon}).

The presence of the p-GaN buried layer 25 allows to obtain a shielding effect of the 2DEG from the substrate voltage (in specific embodiments where a voltage difference must be applied between the source and the substrate).

## Claims

1. An HEMT device (20) comprising:
- a semiconductor body (22) including: a substrate (24), a buried layer (25), having a P-type doping, on the substrate (24), and a heterostructure (27) on the buried layer, wherein the heterostructure comprises a channel layer (30) of intrinsic-type, configured to accommodate, in use, a conductive channel of the HEMT device;
- a source contact (36) extending in depth into the semiconductor body,
**characterized in that** the source contact (36) comprises:
a first contact portion (36a) extending through part of the heterostructure (27) up to reaching the channel layer (30) and ending within the channel layer (30);
a second contact portion (36b) extending completely through the heterostructure (27) and through part of the buried layer (25), ending within the buried layer (25),
wherein the first contact portion (36a) includes a first metal material that extends in direct electrical contact with the channel layer (30) and is for forming an ohmic contact with the channel layer (30), and
wherein the second contact portion (36b) includes a second metal material, different from the first metal material, which extends in direct electrical contact with the buried layer (25) and is for forming an ohmic contact with the buried layer (25).

2. The HEMT device according to claim 1, wherein the first metal material has a work function value comprised between 3.5 and 4.5 eV.

3. The HEMT device according to any of the preceding claims, wherein the second metal material has a work function value comprised between 4.5 and 5.6 eV.

4. The HEMT device according to any of the preceding claims, wherein the first metal material has a work function value lower than the work function value of the second metal material.

5. The HEMT device according to any of the preceding claims, wherein the first metal material is, or includes, titanium or tantalum.

6. The HEMT device according to any of the preceding claims, wherein the second metal material is, or includes, nickel or ruthenium

7. The HEMT device according to any of the preceding claims, wherein the first contact portion (36a) comprises a plurality of layered materials, including: Ti, AlCu, TiN, in particular a Ti/AlCu/TiN stack; alternatively Ta, AlCu, TaN, in particular a Ta/AlCu/TaN stack or a Ta/AlCu/Ta stack.

8. The HEMT device according to any of the preceding claims, wherein the second contact portion (36b) comprises a plurality of layered materials, including: Ni, Au, Pt, Ag, in particular a stack of Ni/Au or Ni/Pt/Au, or Ni/Ag/Au, or Ni/Ag.

9. The HEMT device according to any of the preceding claims, wherein the semiconductor body (22) further comprises a buffer layer (26) between the substrate (24) and the buried layer (25), wherein the buffer layer (26) is of intrinsic or compensated AlGaN or GaN, the buried layer (25) is of P-type doped GaN, the channel layer (30) is of intrinsic GaN, and wherein the heterostructure (27) further comprises a barrier layer (29) of AlGaN on the channel layer (30) and in direct contact with the channel layer (30).

10. The HEMT device according to any of the preceding claims, further comprising a recessed-gate region (32) extending into the semiconductor body and ending within the heterostructure (27), or a doped-gate region (42) extending above the heterostructure (7) and containing P-type doping impurities.

11. A method of manufacturing a HEMT device (20) comprising the steps of:
- forming a source contact (36) in depth in a semiconductor body (22) including: a substrate (24), a buried layer (25), having a P-type doping, on the substrate (24), and a heterostructure (27) on the buried layer, wherein the heterostructure comprises a channel layer (30) of intrinsic-type, configured to accommodate, in use, a conductive channel of the HEMT device,
**characterized in that** the step of forming the source contact (36) comprises:
- forming a first contact portion (36a) through part of the heterostructure (27) up to reaching the channel layer (30) and ending within the channel layer (30), including depositing a first metal material in direct electrical contact with the channel layer (30) and which is for forming an ohmic contact with the channel layer (30); and
- forming a second contact portion (36b) completely through the heterostructure (27) and through part of the buried layer (25), ending within the buried layer (25), including depositing a second metal material, different from the first metal material, in direct electrical contact with the buried layer (25) and which is for forming an ohmic contact with the buried layer (25).

12. The method according to claim 11, wherein forming the source contact (36) comprises performing in order the steps of:
- forming a first trench (50) through part of the heterostructure (27), the first trench (50) having a side wall (50a) and a bottom wall (50b), the bottom wall (50b) exposing the channel layer (30);
- forming a second trench (52) by removing selective portions of the channel layer (30) and the buried layer (25) at the bottom wall (50b) of the first trench (50);
- depositing said first metal material (56) in the first and the second trenches (50, 52);
- removing selective portions of the first metal material (56) from the second trench (52), keeping said first metal material (56) at the side wall (50a) of the first trench (50); and
- depositing said second metal material (58) in the first and the second trenches (50, 52).

13. The method according to claim 12, further comprising the step of performing a rapid thermal process after the step of depositing said second metal material (58).

14. The method according to claim 11, wherein forming the source contact (36) comprises performing in order the steps of:
- forming a first trench (60) through part of the heterostructure (27), the first trench (60) having a side wall (60a) and a bottom wall (60b), the bottom wall (60b) exposing the channel layer (30);
- depositing said first metal material (66) in the first trench (60);
- removing selective portions of the first metal material (66) at the bottom wall (60b);
- forming a second trench (62) by removing selective portions of the channel layer (30) and the buried layer (25) at the bottom wall (60b) of the first trench (60); and
- depositing said second metal material (58) in the first and the second trenches (60, 62).

15. The method according to claim 14, further comprising the steps of:
- performing a first rapid thermal process after the step of depositing said first metal material (66) and before the step of removing selective portions of the first metal material (66); and
- performing a second rapid thermal process after the step of depositing said second metal material (68);
alternatively:
- performing a rapid thermal process of the first metal material (66) and of the second metal material (68) after the step of depositing said second metal material (68).
